(19) Europäisches Patentamt / European Patent Office / Office européen des brevets

(11) **EP 4 198 538 B1**

(12) **FASCICULE DE BREVET EUROPEEN**

(45) Date de publication et mention
de la délivrance du brevet:
**13.08.2025 Bulletin 2025/33**

(21) Numéro de dépôt: **22209552.3**

(22) Date de dépôt: **25.11.2022**

(51) Classification Internationale des Brevets (IPC):
**G01R 31/379** (2019.01)    **G01R 31/3828** (2019.01)
**G01R 31/3832** (2019.01)    **G01R 31/389** (2019.01)
**G01R 31/392** (2019.01)

(52) Classification Coopérative des Brevets (CPC):
**G01R 31/392; G01R 31/379; G01R 31/3828;
G01R 31/3832; G01R 31/389;** Y02E 60/10

(54) **MÉTHODE DE DIAGNOSTIC ET DE PRÉDICTION DE DURÉE DE VIE DE BATTERIES AU PLOMB, NOTAMMENT DESTINÉES AU STOCKAGE D'ÉNERGIE DE SECOURS**

VERFAHREN ZUR DIAGNOSE UND VORHERSAGE DER LEBENSDAUER VON BLEIBATTERIEN, INSBESONDERE ZUR SPEICHERUNG VON NOTENERGIE

METHOD FOR DIAGNOSING AND PREDICTING SERVICE LIFE OF LEAD ACID BATTERIES, IN PARTICULAR FOR STORING BACKUP ENERGY

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **14.12.2021 FR 2113461**

(43) Date de publication de la demande:
**21.06.2023 Bulletin 2023/25**

(73) Titulaire: **Commissariat à l'Energie Atomique et aux Energies Alternatives
75015 Paris (FR)**

(72) Inventeurs:
• **KIRCHEV, Angel Zhivkov
38054 GRENOBLE CEDEX 09 (FR)**
• **GUILLET, Nicolas
38054 GRENOBLE CEDEX 09 (FR)**
• **SERRA, Lionel
38054 GRENOBLE CEDEX 09 (FR)**

(74) Mandataire: **Ipsilon
11 rue Saint-Georges
75009 Paris (FR)**

(56) Documents cités:
US-A1- 2009 027 056    US-A1- 2018 267 111
US-A1- 2019 383 881

EP 4 198 538 B1

**Description**

**Domaine technique**

La présente invention concerne le domaine du stockage de l'énergie et plus particulièrement celui des batteries plomb-acide.

Elle a trait plus particulièrement à une méthode de diagnostic de telles batteries et avantageusement de prédiction de leur durée de vie.

Bien que décrite en référence à des batteries plomb-acide, l'invention s'applique de manière plus générale à tout accumulateur électrochimique à électrolyte aqueux aussi appelé « batterie aqueuse ».

Bien que décrite en référence à une application privilégiée de stockage de secours, l'invention s'applique à toute application stationnaire.

**Technique antérieure**

Une batterie dite « stationnaire » est une batterie qui reste là où elle a été placée, en opposition aux batteries de traction et de démarrage, soumises à des déplacements, vibrations... Les deux grands secteurs d'applications stationnaires sont les alimentations de secours et le photovoltaïque.

Dans de nombreuses applications où l'interruption de l'alimentation électrique principale, à savoir le réseau électrique, peut entraîner des conséquences graves de différents types (danger pour la santé humaine, dommages matériels, pertes financières ...), les systèmes sont sécurisés par des alimentations de secours. On peut citer ici les réseaux des opérateurs de télécommunications, les hôpitaux, les centrales de production d'électricité et les grands centres informatiques de gestion (centres financiers, centres de contrôle des trafics aériens et ferroviaires...), ....

En cas de défaillance du réseau principal, l'alimentation de secours a pour fonction de fournir l'énergie pour laquelle elle a été dimensionnée. Lorsque l'alimentation de secours doit se substituer au réseau électrique, et fournir une tension alternative de même valeur efficace, celle-ci est communément désignée sous l'acronyme « A.S.I. » pour Alimentation Sans Interruption (ou U.P.S. acronyme anglo-saxon pour « Uninterruptible Power Supply »).

Une alimentation de secours est dimensionnée pour pallier les perturbations du réseau électrique à secourir. Ces dernières peuvent être de nature différente: coupures de tension, coupures brèves de tension et creux de tension, microcoupures, surtensions,. Une alimentation de secours peut ainsi être sollicitée sur quelques dizaines de millisecondes à quelques minutes.

Les batteries rechargeables sont utilisées comme alimentation de secours.

Les batteries au plomb sont la technologie préférée dans de nombreuses applications de secours en raison de leur faible coût combiné à une maturité technologique. L'exigence de faible coût est liée au fait que la batterie est rarement utilisée (c'est-à-dire déchargée), restant ainsi en mode veille sur 99% de sa durée de vie. D'autre part, la maturité de la technologie des batteries au plomb est un autre avantage clé, car de telles applications nécessitent des systèmes de stockage d'énergie très prévisibles fonctionnant sans possibilité de panne soudaine.

Une batterie au plomb est un ensemble d'accumulateurs au plomb-acide sulfurique reliés en série, afin d'obtenir la tension désirée, et baignant dans un électrolyte liquide constitué d'eau déminéralisée et d'acide sulfurique, le tout étant logé dans un même boîtier.

Afin d'intervenir immédiatement en cas de défaillance du réseau, les batteries de secours nécessitent d'être constamment maintenues à l'état chargé. Le mode de maintien classique de l'état chargé est appelé « charge flottante » (« floating » en langage anglo-saxon) : les phénomènes d'autodécharge sont compensés en imposant à la batterie une tension supérieure à sa tension de circuit ouvert (de l'ordre de 100 à 150mV par élément).

Cette tension provoque un courant de charge flottant ou autrement dit de maintien de charge. Ce courant est permanent : pour une batterie, par exemple de capacité 100Ah, à 20°C, l'intensité du courant de la charge flottante peut se stabiliser à une valeur de l'ordre de 30mA.

Plus précisément, la charge flottante est une surcharge contrôlée en tension appliquée en continu visant à compenser les processus d'autodécharge qui peuvent être exprimés par les équations suivantes :

$$\text{A l'électrode négative: } Pb + H_2SO_4 \rightarrow PbSO_4 + H_2\uparrow \qquad (1)$$

$$\text{A l'électrode positive: } PbO_2 + H_2SO_4 \rightarrow PbSO_4 + H_2O + \tfrac{1}{2}O_2\uparrow \qquad (2)$$

L'excès de charge, restant après la compensation des processus d'autodécharge, entraîne le déroulement de réactions électrochimiques parasites, à savoir un dégagement d'oxygène et de corrosion du collecteur de courant à l'électrode positive et un dégagement de recombinaison d'hydrogène et d'oxygène (dans le cas piles) à l'électrode négative. Ces réactions parasites peuvent être exprimées par les équations suivantes:

$$\text{Électrolyse de l'eau : } H_2O \rightarrow 2H_2\uparrow + O_2\uparrow \qquad (3)$$

$$\text{Dégagement d'hydrogène à l'électrode négative: } 4H^+ + 4e^- \rightarrow 2H_2\uparrow \qquad (4a)$$

$$\text{Dégagement d'oxygène à l'électrode positive: } 2H_2O \rightarrow O_2\uparrow + 4H^+ + 4e^- \qquad (4b)$$

$$\text{Corrosion de la grille (collecteur de courant positif): } Pb + 2H_2O \rightarrow PbO_2 + 2H_2\uparrow \qquad (5)$$

$$\text{Recombinaison d'oxygène à l'électrode négative: } O_2 + 4H^+ + 4e^- \rightarrow 2H_2O \qquad (6)$$

La combinaison des réactions (4b) et (6) forme ce que l'on appelle le cycle de l'oxygène, qui permet un fonctionnement sans entretien des batteries au plomb-acide désignés sous le nom de batteries au plomb-acide à régulation de soupape (VRLA acronyme anglo-saxon pour « Valve Regulated Lead Acid »). Ces batteries sont équipées d'un système d'évacuation à soupape de sécurité conçu pour dégager la pression interne excessive tout en maintenant une pression suffisante pour recombiner l'oxygène et l'hydrogène en eau.

En revanche, les réactions (4a) et (5) peuvent être considérées comme des processus irréversibles provoquant une dégradation progressive d'une batterie plomb-acide.

La dégradation se déroule selon deux processus parallèles :

- d'une part, les réactions consomment de l'eau provoquant un dessèchement de l'électrolyte,
- d'autre part, le collecteur de courant métallique est transformé en $PbO_2$ qui est plus résistif et cassant, i.e. l'électrode positive perd de sa capacité en raison d'une perte d'intégrité structurelle due au processus de corrosion.

La progression de ces deux processus entraîne une augmentation de la résistance de la batterie et une perte de capacité de stockage d'énergie.

Les applications de stockage d'énergie de secours nécessitent la connaissance de deux types de paramètres de diagnostic pour les batteries utilisées au sein du système de secours : la capacité réelle de chaque batterie, c'est-à-dire son état de santé (SOH acronyme anglo-saxon pour « State Of Health ») et la durée de vie restante de la batterie, afin d'assurer une maintenance préventive adéquate du système.

A ce jour, l'estimation quantitative de la dégradation d'une batterie de secours peut être réalisée selon deux méthodes principales.

La première méthode principale, qui est la plus précise, consiste à réaliser la décharge complète de la batterie avec un courant constant ou une puissance constante. Par convention, on considère que la batterie est complètement chargée avant ce test de décharge en raison des spécifications d'un système de stockage d'énergie de secours. Les résultats de ce test peuvent être présentés directement comme « État de santé » par la normalisation de la capacité de décharge (Cd) par rapport à une valeur de capacité de référence (Cref). L'état de santé SOH s'exprime ainsi par la relation :

$$\text{SOH} = 100 \times Cd / Cref \qquad (7)$$

Malgré sa précision, cette méthode ne peut fournir qu'une information sur l'état réel de la batterie, c'est-à-dire qu'elle ne peut pas fournir de prédiction sur la durée de vie restante de la batterie. La mise en œuvre de cette méthode en dehors d'un laboratoire prévu à cet effet est également limitée car elle nécessite de longues périodes de mesure et de recharge. L'autre méthode principale consiste en une estimation de la résistance interne de la batterie, ou de sa conductance électrique si sa valeur inversée est prise en compte, soit par des mesures d'impédance, soit par l'application d'impulsions de décharge continue et sa corrélation avec la capacité de la batterie ou son SOH estimé par la méthode de décharge complète mentionnée précédemment. Cette approche est largement utilisée dans l'industrie des batteries, en particulier par la société Midtronics Inc., qui est l'un des principaux fabricants de dispositifs de test rapide de batteries. On pourra se référer également à la publication [1] qui décrit en détail cette méthode. Tout comme la méthode de décharge complète, cette méthode d'estimation de la résistance interne ne peut pas fournir de prédiction sur la durée de vie restante de la batterie.

Le document US2018/267111 A1 divulgue une méthode de diagnostic d'un accumulateur ou batterie à électrolyte aqueux selon l'état de la technique.

Il existe donc un besoin d'améliorer les méthodes de diagnostic de batteries à électrolyte liquide de type plomb-acide et avantageusement à des fins de prévisions de leur durée de vie notamment pour des applications de stockage d'énergie de secours.

Le but de l'invention est de répondre au moins en partie à ce besoin.

**Exposé de l'invention**

Pour ce faire, l'invention concerne, sous l'un de ses aspects, une méthode de diagnostic d'un accumulateur ou batterie à électrolyte aqueux, notamment une batterie plomb-acide, comprenant les étapes suivantes :

a/ mesure continue d'un courant de surcharge ($I_{ovch}$) appliquée à la batterie ;

b/ mesure périodique, sous courant continu, de la résistance interne ($R_{120s}$) de la batterie,

c/ normalisation d'un paramètre issu du courant de surcharge mesuré selon l'étape a/ et de la résistance interne mesurée selon l'étape b/ ;

d/ estimation de l'écart du logarithme de la résistance interne normalisée selon l'étape c/, considérée pour le paramètre issu du courant de surcharge normalisé selon l'étape c/, par rapport à une droite d'étalonnage, obtenue à partir d'une régression linéaire de mesures d'étalonnage de résistance interne et courant de surcharge d'une batterie de référence ;

e/ comparaison de l'écart ($\Delta$) estimé par rapport une valeur seuil prédéterminée en fonction du type de la batterie :

- si l'écart est positif et supérieur à cette valeur seuil alors nécessité de changer la batterie du fait de son vieillissement prématuré ;
- si l'écart est négatif et inférieur à cette valeur seuil alors pas de nécessité de changer la batterie.

Selon une variante de réalisation avantageuse, le paramètre issu du courant de surcharge mesuré est l'intégration ($Q_{ovch}$) du courant de surcharge flottante lorsque la tension de la batterie est maintenue à une valeur de charge flottante comprise entre 2,25V et 2,3V/accumulateur.

Selon une autre variante de réalisation avantageuse, la normalisation de la résistance interne selon l'étape c/ est réalisée en divisant la résistance interne mesurée ($R_{120s}$) par la résistance interne de la batterie neuve mesurée sous courant alternatif à 1kHz ou d'une batterie neuve de référence du même type.

Selon une autre variante de réalisation avantageuse, la normalisation du courant de surcharge selon l'étape c/ est réalisée en divisant l'intégration du courant de surcharge mesuré ($Q_{ovch}$) par la capacité nominale (Cn) de la batterie, définissant l'indice de surcharge ($N_{ovch}$).

Selon un mode de réalisation avantageux, le procédé comprend en outre les étapes suivantes :

f/ estimation du rapport ($\frac{Nmax}{Novch}$) entre la limite de surcharge ($N_{max}$) et l'indice de surcharge ($N_{ovch}$) ;

g/ comparaison du rapport ($\frac{Nmax}{Novch}$) estimé à l'étape f/ par rapport à 1 :

- si le rapport ($\frac{Nmax}{Novch}$) estimé est inférieur à 1, alors nécessité de changer la batterie du fait de son vieillissement normal dépassé.

Selon encore un mode de réalisation avantageux, le procédé comprend en outre l'étape suivante :

- si le rapport ($\frac{Nmax}{Novch}$) comparé à l'étape g/ est supérieur à 1, et
- si la valeur absolue de l'écart ($\Delta$) estimé à l'étape d/ est inférieur à la valeur seuil prédéterminée, alors

h/ détermination de la durée de vie restante de la batterie (RBLT) à partir de l'équation :

$$RBLT = \left( \frac{N_{max}}{N_{ovch}} - 1 \right) * BOT$$

dans laquelle BOT désigne la durée de mise en service réelle de la batterie.

De préférence, la mesure périodique de la résistance interne ($R_{120s}$) de la batterie selon l'étape b/ est réalisée par l'application d'un courant de charge ou de décharge sur un intervalle de temps fixe.

De préférence encore, l'intervalle de temps fixe est entre 60 et 180 secondes pour un courant de décharge correspondant à la capacité nominale (Cn).

L'invention a encore pour objet un système de contrôle d'une batterie à électrolyte aqueux (BMS) pour la mise en œuvre de la méthode qui vient d'être décrite le système comprenant des capteurs de mesure et un processeur configuré pour fournir, à partir des mesures réalisées par les capteurs, à pour fournir à l'utilisateur des messages d'alerte soit de de défaillance de la batterie, soit de fonctionnement correct de la batterie, et de préférence un message d'indication de la durée de vie restante de la batterie (RBLT).

L'invention a encore pour objet l'utilisation de la méthode de diagnostic ou du système qui viennent d'être décrits dans une application où la batterie sert de stockage d'électricité de secours, telle que dans les stations de télécommunications, les centres de données, les installations nucléaires, ou sert de support et de sauvegarde du réseau basse tension d'une voiture électrique.

Ainsi, l'invention consiste essentiellement en une nouvelle méthode de diagnostic de batteries de type plomb-acide et avantageusement d'estimation de leurs durées de vie restantes, plus particulièrement destinées à des applications de stockage de secours.

La méthode est basée sur une combinaison de mesures de surveillance continue avec intégration du courant de surcharge (calcul des Ah de surcharge appliqués à la batterie dès son installation) et de mesures périodiques sous courant continu de la résistance interne de la batterie en utilisant de courtes périodes de décharge avec un courant constant ou une puissance constante. Il peut s'agir d'un courant ou d'une puissance nominale de 1h, par exemple 1A/Ah ou 1W/Wh.

Les résultats de ces mesures sont comparés à un ensemble de données d'étalonnage obtenu après régression linéaire à partir de tests en laboratoire du type de la batterie au plomb sélectionné.

Les comparaisons donnent lieu à des indications de diagnostic selon lesquelles la batterie surveillée présente un vieillissement normal ou prématuré (et donc à changer).

A partir également de ces comparaisons, il est possible d'indiquer une prédiction de durée de vie restante en termes de jours, de mois ou d'années de service.

Les avantages d'une méthode de diagnostic d'un accumulateur ou batterie selon l'invention comparativement aux méthodes selon l'état de l'art sont nombreux parmi lesquels on peut citer :

- une méthode fiable et qui peut être reproduite à souhait pour tout type de technologie de batteries à électrolyte aqueux in situ, c'est-à-dire sans avoir à déplacer les batteries de leur lieu d'utilisation commerciale, à partir de batteries de référence testées en laboratoire qui servent pour établir les données d'étalonnage ;

- une méthode de prédiction de durée de vie restante.

La méthode de diagnostic selon l'invention est applicable aux applications de stockage d'énergie de secours mettant en oeuvre des batteries à électrolyte aqueux. Ces applications incluent les stations de télécommunications, les centres de données, les installations nucléaires. De telles applications exigent un faible coût et une bonne prévisibilité et elles n'impliquent pas de cycles de charge/décharge intenses. Ces spécifications sont remplies avec succès par plusieurs technologies différentes de batteries au plomb et certaines études de marché récentes montrent que la situation restera à peu près la même au moins à moyen terme. Par exemple, la présentation [2] indique un horizon à 2030.

Un autre segment de marché du stockage d'énergie qui peut être intéressé par la méthode de diagnostic selon l'invention est le marché du véhicule électrique. La plupart des véhicules électriques utilisent des batteries plomb-acide à 12 V pour le support et la sauvegarde du réseau basse tension de la voiture, c'est-à-dire un cas typique d'application de stockage d'énergie en veille). Selon la présentation [2], les batteries plomb-acide resteront l'option privilégiée dans ce domaine au moins à moyen terme, jusqu'à 2030.

D'autres avantages et caractéristiques de l'invention ressortiront mieux à la lecture de la description détaillée d'exemples de mise en œuvre de l'invention faite à titre illustratif et non limitatif en référence aux figures suivantes.

## Brève description des dessins

[Fig 1A], [Fig 1B] les figures 1A et 1B sont des courbes illustrant l'évolution temporelle de la capacité et de l'impédance haute fréquence d'un premier groupe de batteries lors de leur vieillissement en imposant une charge flottante à 2,27V/accumulateur à 60°C, comme selon l'état de l'art.

[Fig 2A], [Fig 2B] les figures 2A et 2B sont des courbes illustrant l'évolution temporelle de la capacité et de l'impédance haute fréquence d'un deuxième groupe de batteries lors de leur vieillissement en imposant une charge flottante à 2,27V/accumulateur à 60°C, comme selon l'état de l'art.

[Fig 3A], [Fig 3B] les figures 3A et 3B sont des courbes illustrant l'évolution temporelle de la capacité et de l'impédance haute fréquence des batteries lors du vieillissement en imposant une charge flottante à 2,27V/accumulateur à 50°C, comme selon l'état de l'art.

[Fig 4A], [Fig 4B], [Fig 4C], [Fig 4D] sont des courbes illustrant l'évolution temporelle de tension de décharge de contrôle sur les batteries au cours du vieillissement à 60°C, les figures 4B et 4D étant des grossissements temporels respectivement des figures 4A et 4C.

[Fig 5A], [Fig 5B] les figures 5A et 5B sont des courbes illustrant l'évolution temporelle de la résistance interne ($R_{120s}$) sous courant continu des batteries lors de leur vieillissement, selon l'invention.

[Fig 6A], [Fig 6B] les figures 6A et 6B sont des courbes illustrant l'évolution temporelle du courant de surcharge de certaines des batteries lors de leur vieillissement accéléré en imposant une charge flottante à 2,27V/accumulateur à 60°C, selon l'invention.

[Fig 7A], [Fig 7B] les figures 7A et 7B sont des courbes illustrant l'évolution temporelle de la surcharge cumulée des batteries lors de leur vieillissement accéléré en imposant une charge flottante à 2,27V/accumulateur à 60°C et 50°C, selon l'invention.

[Fig 8A], [Fig 8B], [Fig 8C] les figures 8A, 8B, 8C sont des courbes illustrant la corrélation entre la surcharge électrique ($Q_{ovch}$) et la résistance interne ($R_{120s}$) sous courant continu des batteries à 60°C et 50°C, établie à partir des mesures selon les figures 5A à 7B.

[Fig 9] la figure 9 illustre la corrélation linéaire entre le logarithme de la résistance interne sous courant continu normalisée et la surcharge normalisée pour des batteries présentant un comportement de vieillissement correct.

[Fig 10A], [Fig 10B] les figures 10A et 10B illustrent les écarts entre le logarithme de la résistance interne sous courant continu normalisée en fonction de la surcharge normalisée de batteries présentant un défaut de vieillissement correct par rapport à une droite d'étalonnage obtenue à partir de la corrélation linéaire de la figure 9 pour une batterie présentant un comportement de vieillissement correct.

[Fig 11A], [Fig 11B] les figures 11A et 11B illustrent selon la valeur du logarithme de la résistance interne sous courant continu normalisée en fonction de la surcharge normalisée d'une batterie, l'estimation de la durée de vie restante de la batterie dans un cas de vieillissement correct et dans un cas de vieillissement prématuré.

[Fig 12] la figure 12 est un organigramme de l'algorithme de la méthode de diagnostic d'une batterie et d'estimation de la durée de vie restante de la batterie (RBLT) selon l'invention.

## Description détaillée

On précise que dans la description qui va suivre la tension de 2,27V/accumulateur fait référence à la tension égale à 2,27V par accumulateur d'une batterie qui comprend dans l'exemple trois accumulateurs.

Technologie de batteries

Les inventeurs ont comparé les méthodes de diagnostic selon l'état de l'art et mis en œuvre leur méthode de diagnostic et de prédiction de la durée de vie de batteries à partir d'un modèle de batteries déjà commercialisées sous la référence « Sprinter XP6V2800 » fabriquée par la société Exide.

Cette batterie commercialisée met en œuvre une technologie de type plomb-acide de batterie de tension égale à 6V à régulation de soupape (VRLA) et dont l'électrolyte liquide est absorbé et immobilisé dans des buvards en fibre de verre (AGM acronyme anglo-saxon pour « *Absorbed Glass Mat* »), et qui comprend trois accumulateurs et a une capacité nominale de 195Ah.

Typiquement ces batteries sont installées dans différents centres de données (en anglais « data centers ») en tant que batteries de stockage d'énergie de secours.

On précise ici que les batteries testées sont désignées ci-après et sur les figures par l'acronyme « XP6Vnn » où nn est la référence numérique qui désigne une des batteries.

Protocole expérimental

Trois groupes de quatre batteries distinctes ont chacun été soumis à un vieillissement accéléré en utilisant la tension de charge flottante de 2,27 V/accumulateur et des températures élevées à deux niveaux de température. Ainsi, le groupe constitué des batteries XP6V06, XP6V07, XP6V08, XP6V09, a été soumis à une température de 50 °C. Les groupes constitués des batteries XP6V01, XP6V03, XP6V04, XP6V05, d'une part et XP6V11, XP6V12, XP6V13, XP6V14, ont été testés à une température de 60 °C.

Des tests de contrôle périodiques à 25°C sont réalisées après 4 à 5 semaines de vieillissement accéléré à température élevée.

Le protocole de contrôle commence par la mesure sous courant alternatif de l'impédance interne de la batterie à 1 kHz en circuit ouvert, suivie d'une décharge complète avec un courant constant égal à 195A (courant de 1h ou C/1h) jusqu'à ce que la tension de la batterie atteigne la valeur de 1,6V/accumulateur. Cette mesure est réalisée à l'aide de l'instrument commercialisé sous la dénomination HIOKI HiTESTER 3554 par la société HIOKI.

Après le processus de décharge, la batterie est rechargée avec un régime à courant constant ou tension constante commençant à 19,5 A avec une limite de tension de 2,4 V/accumulateur.

La tension de charge flottante passe à 2,27 V/ accumulateur, 24h après le début de la charge et cette tension de charge flottante est maintenue jusqu'au début de la prochaine procédure de contrôle.

La température est augmentée de 25°C à 50 ou 60°C dans les jours suivant la réalisation d'autres tests de batterie inclus dans la procédure de contrôle. Ces autres tests, non électriques sont non invasifs et n'impactent pas l'électrochimie de la batterie. Ils n'impactent donc pas les mesures de diagnostic selon l'état de l'art et selon l'invention.

Méthodes de diagnostic de la batterie selon l'état de l'art

Des mesures de décharge complète et d'impédance interne sous courant alternatif à haute fréquence à 1kHz ont été réalisées sur les batteries.

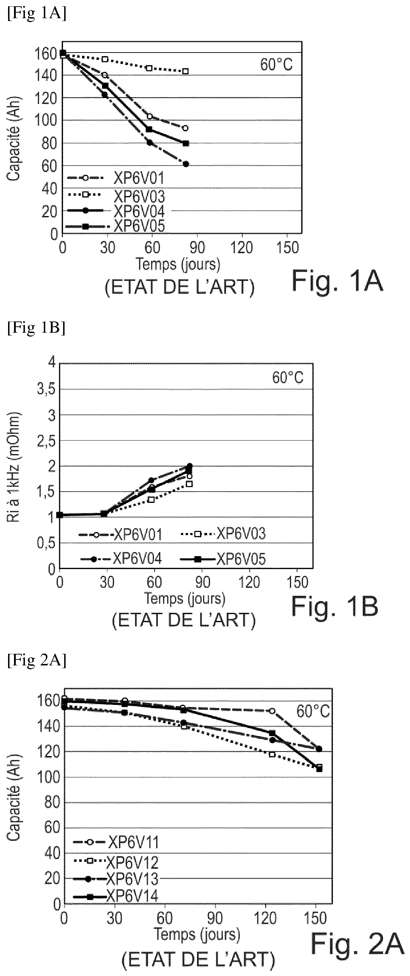

Les figures 1A, 1B, 2A, 2B et 3A, 3B résument les résultats des diagnostics de batterie lors du vieillissement en imposant une charge flottante à 2,27V/accumulateur respectivement à 60°C sur des groupes de batteries différents et à 50°C.

Le premier groupe de batteries testé à 60°C a montré une diminution rapide de la capacité de trois batteries, ce qui signifie une défaillance prématurée, à savoir XP6V01, XP6V04, XP6V05 et un vieillissement plus lent de l'autre batterie, XP6V03 (figure 1A). Il a été estimé que les trois batteries de qualité inférieure appartiennent à un lot de fabrication étiqueté avec une première date de fabrication (Mai 2019), tandis que la batterie de qualité correcte est étiquetée avec une deuxième date de fabrication (Novembre 2018).

La mesure de l'impédance haute fréquence (résistance interne à 1kHZ) montre une corrélation assez faible avec la capacité, surtout en début de vieillissement (figure 1B). La résistance interne de la batterie correcte XP6V03 reste la plus faible, cependant la différence par rapport aux autres batteries savoir XP6V01, XP6V04, XP6V05 reste relativement faible. Ces données indiquent que la résistance interne à haute fréquence n'est pas un paramètre très sensible pour l'estimation de l'état de santé SOH et qu'elle ne peut pas être utilisée à des fins prédictives. En effet, ces tests révèlent que l'évolution temporelle de l'impédance de 1 kHz reste similaire pour les bonnes et les batteries à défaillance prématurées.

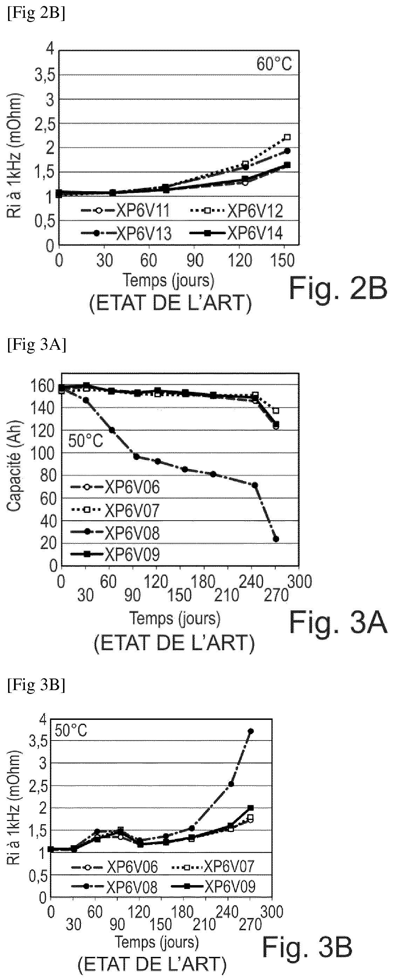

La figure 2A représente une évolution temporelle de la capacité des batteries XP6V11, XP6V12, XP6V13, XP6V14, assez similaire à celle de la batterie correcte XP6V03. Ces résultats sont en accord avec les informations de la fiche technique de ces batteries, qui indiquent une durée de vie de la batterie de 6 mois à 60°C et sous tension de 2,27V/accumulateur. La décroissance de la capacité n'est pas linéaire et il existe une certaine dispersion des points de données. La figure 2B montre également une augmentation lente de la résistance interne des batteries XP6V11, XP6V12, XP6V13, XP6V14, qui est en faible corrélation avec l'évolution temporelle de la capacité. Ces résultats diffèrent nettement des données des figures 1A et 1B, où une augmentation significative de l'impédance haute fréquence est observée après le premier mois de vieillissement.

La figure 3A montre une évolution de la capacité et de l'impédance haute fréquence des batteries XP6V06, XP6V07, XP6V08, XP6V09 lors du vieillissement en imposant une charge flottante à 2,27V/accumulateur à 50°C. On constate que le vieillissement de ces batteries est nettement plus lent que celui des batteries précédemment citées. Les trois batteries XP6V06, XP6V07, XP6V09 qui correspondant au lot de fabrication étiqueté avec la deuxième date de fabrication perdent de leur capacité très lentement, tandis que la batterie XP6V08 provenant du lot de fabrication étiqueté avec la première date de fabrication se dégrade rapidement. Cela confirme l'hypothèse que la défaillance prématurée est liée à des problèmes de qualité de fabrication. Le taux de vieillissement des batteries correctes XP6V06, XP6V07, XP6V09 est en accord avec les informations de la fiche technique de ces batteries qui indiquent une durée de vie de la batterie égale à 12 mois à 50°C et sous tension de 2,27V/accumulateur. L'évolution de la capacité des batteries correctes à 50°C correspond très bien au comportement théorique d'un vieillissement de batterie de secours : la capacité décroît très lentement du fait de l'absence de cyclage charge/décharge intense jusqu'à un point d'inflexion. Ce point d'inflexion correspond à une certaine épaisseur critique de la couche de corrosion formée à la surface des collecteurs de courant positifs.

Au-delà de cette épaisseur, la résistance électrique et l'intégrité mécanique du collecteur de courant commencent à se dégrader beaucoup plus rapidement, ce qui correspond à une perte rapide de la capacité. Cela se traduit par le point d'inflexion de la capacité entre 8 et 9 mois de vieillissement sur la figure 3A.

A la lecture de la figure 3B, on constate également que l'évolution temporelle de l'impédance haute fréquence ne correspond pas bien à celle de la capacité. On voit aussi que des différences significatives de capacité peuvent correspondre à de très faibles différences d'impédance à 1 kHz.

Méthode de diagnostic de batterie par mesures de la résistance interne sous courant continu L'estimation de la résistance interne sous courant de la batterie (RDC) peut être exprimée à l'aide de la loi d'Ohm comme suit :

$$R_{DC} = \Delta U \, / \, \Delta I \qquad (8)$$

où $\Delta U$ est la variation de la tension de la batterie due à l'application d'un certain courant de charge ou de décharge égal à $\Delta I$ sur un intervalle de temps fixe.

La durée de cet intervalle de temps est liée aux constantes de temps des différents processus électriques et électrochimiques se déroulant dans la batterie pendant l'opération de charge/décharge. Par exemple, une durée restant dans la plage de 1 à 5 ms fournira des valeurs $R_{DC}$ proches de celles mesurées par l'instrument Hioki sous courant alternatif avec une fréquence de 1 kHz.

Les inventeurs ont analysé en détail l'évolution temporelle des courbes de tension de la batterie lors d'une décharge de contrôle à 25°C avec un courant constant égal à 195A (C/1h), afin de sélectionner des conditions optimales pour la mesure de la résistance interne $R_{DC}$ (et plus précisément $\Delta U$ ).

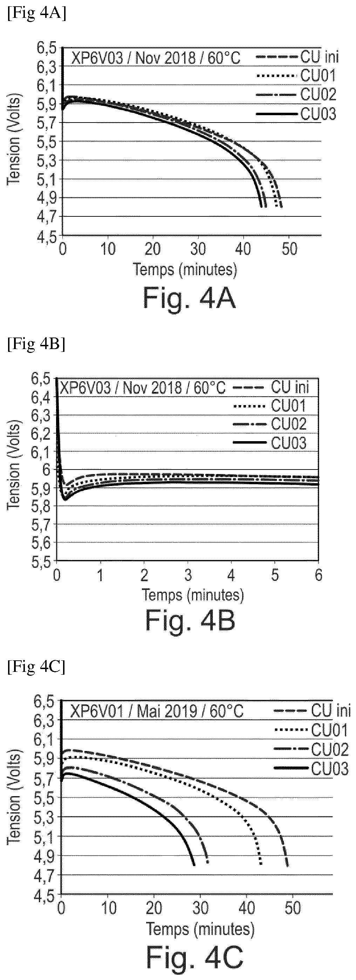

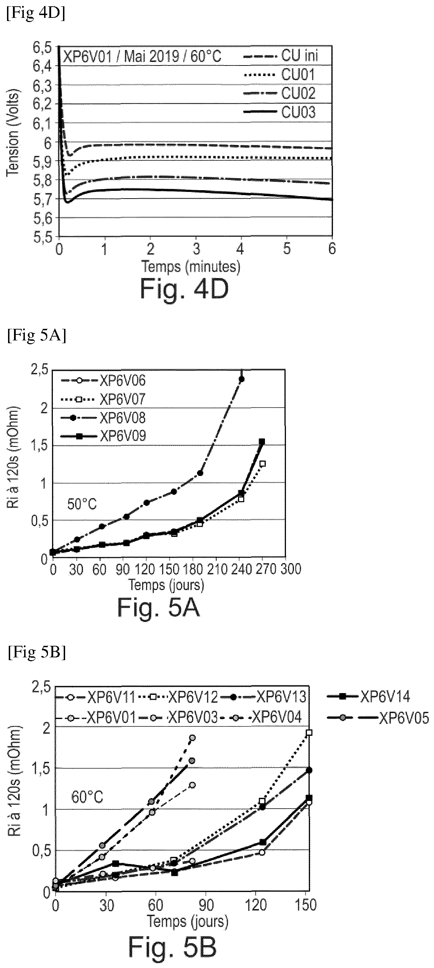

Les figures 4A à 4D montrent cette évolution pour le cas de deux batteries XP6V03 et XP6V01 du premier groupe ayant subi un vieillissement à 60°C. Le zoom des données pendant les 6 premières minutes de la décharge indique une bonne corrélation entre la tension de la batterie, le vieillissement et l'évolution de la capacité, notamment dans la période initiale de 1 à 3 min, correspondant à 1,5 à 5 % de la capacité nominale de la batterie, où la tension tend vers un plateau (figures 4B et 4D). Ce résultat permet de considérer la tension de la batterie mesurée après 2 min de décharge (notée $U_{120s}$) avec un courant égal à 1C comme l'un des paramètres définissant $\Delta U$.

L'inspection de toutes les données mesurées au cours des tests, ainsi que l'étude du comportement électrique d'autres batteries au plomb lors d'une décharge avec un courant proche de 1C suggèrent qu'une tension de référence de base égale à 2V/batterie, ou 6V /batterie pour celles de la présente étude, est un choix empirique approprié.

Ainsi, les inventeurs ont décidé de retenir la résistance interne sous courant continu, dénommée ci-après R120s, comme indicateur de la méthode proposée pour le diagnostic de la batterie.

Cette résistance interne sera calculée selon l'équation suivante :

$$R_{120s} = (6V - U_{120s})/195A \qquad (9)$$

L'évolution temporelle de la résistance interne sous courant continu ($R_{120s}$) au cours du vieillissement des trois groupes de batteries précités est montrée sur les figures 5A et 5B.

Il ressort de ces figures que l'utilisation de ce paramètre, $R_{120s}$, permet de distinguer facilement les batteries correctes et les batteries défectueuses, ces dernières présentant une augmentation de la résistance interne bien plus rapide.

On voit aussi que la diminution de la température de 10°C (60°C de la figure 5B à 50°C de la figure 5A) ralentit l'évolution temporelle des résistances internes $R_{120s}$ avec un facteur de l'ordre de 2, ce qui correspond à l'équation d'Arrhenius.

Au final, la comparaison de l'évolution temporelle des résistances internes R120s avec celle de la capacité des batteries indique que des valeurs de R120s dans l'intervalle de 1 à 2 mOhms peuvent être utilisées comme un indicateur de l'approche de la fin de vie de la batterie.

Surveillance du vieillissement de la batterie utilisant l'intégration du courant de surcharge Il ressort des données des figures précédentes (figures 1A à 5B) que la température impacte très fortement le taux de vieillissement des batteries qui sont particulièrement destinées à des applications de stockage de secours.

En outre, la température ambiante dans les locaux dans lesquels les batteries sont logées est rarement constante.

Cela rend difficile la quantification du vieillissement de la batterie et l'estimation de sa durée de vie restante.

Le faible nombre de cycles de charge/décharge profonde dans les applications de stockage de secours permet de considérer que les matériaux actifs des deux électrodes (anode, cathode) de chaque batterie ne se dégradent pas tout au long du vieillissement.

Ainsi, on peut considérer que les réactions décrites en relation avec les équations (3) à (6) sont la seule cause de pertes de performance des batteries.

Selon la loi de Faraday liant le nombre d'espèces participant à la réaction électrochimique au nombre de charges traversant le circuit électrique externe, la progression du vieillissement d'une batterie est proportionnelle au courant de surcharge et à la surcharge électrique, i.e. les ampères-heures surchargés.

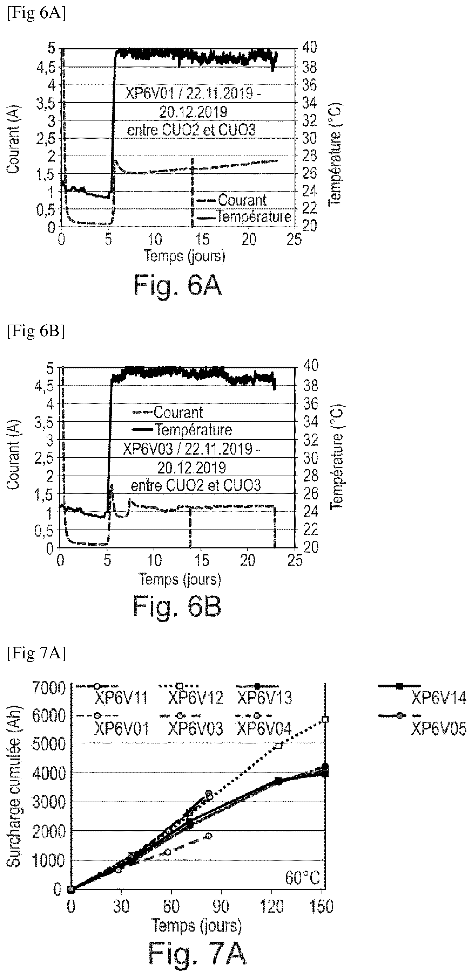

Les figures 6A et 6B présentent l'évolution du courant de surcharge au cours d'un vieillissement accéléré en imposant une charge flottante à 2,27V/accumulateur respectivement à 60°C pour le cas de deux batteries XP6V03 et XP6V01 du premier groupe. On précise ici que l'acronyme CU utilisé sur ces figures signifie « check-up », c'est-à-dire une mesure périodique de capacité et la résistance interne. Les numéros 01, 02, 03... suivants CY signifient quant à eux les numéros de chaque manipulation correspondante.

On peut voir que peu de temps après l'augmentation de la température, le courant de surcharge augmente également et reste dans une même plage, mais sans être constant. C'est pourquoi, les inventeurs pensent qu'il est beaucoup plus pratique d'utiliser le signal de courant intégré en mode de surcharge flottante, comme paramètre rendant compte du vieillissement de la batterie.

Le courant intégré correspond à un calcul des ampères-heures surchargés. Les ampères-heures surchargés peuvent être calculés de plusieurs manières différentes.

L'approche la plus précise est la soustraction des ampères-heures déchargés de la charge totale appliquée à la batterie :

$$Q_{ovch} = \int_0^\tau I_{ch}\,dt - \int_0^\tau |I_{dsch}|\,dt \qquad (10)$$

Une méthode approximative de calcul de $Q_{ovch}$ est l'intégration du courant appliqué en mode de surcharge flottante lorsque la tension de la batterie est maintenue à 2,27V/accumulateur.

Une telle approche peut être très efficace lorsque la batterie est d'abord rechargée avec un régime de courant continu/tension continue avec une tension de l'ordre de 2,35 à 2,40V/accumulateur après la fin de la charge.

Dans ce mode de charge à tension constante, l'état de charge de la batterie dépasse 99% après une durée de 4 à 5h, tandis que la surcharge reste négligeable.

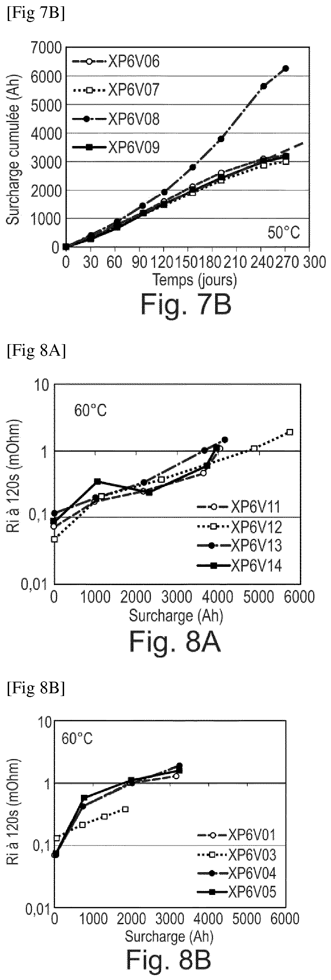

Les figures 7A et 7B présentent l'évolution de la surcharge cumulée ($Q_{ovch}$) mesurée au cours du vieillissement des trois groupes de batteries précités, respectivement à 60°C et à 50°C.

Il ressort de ces figures 7A et 7B que la majorité des batteries arrivent en fin de vie lorsque la quantité de surcharge totale appliquée atteint 4000Ah. Cette valeur est pratiquement la même aux deux températures de vieillissement (50°C et 60°C). Les batteries défectueuses, qui vieillissent plus rapidement, absorbent une surcharge plus élevée, c'est-à-dire qu'elles sont surchargées avec un courant plus élevé, ce qui est corroboré par les figures 6A et 6B. L'évolution temporelle de surcharge cumulée ($Q_{ovch}$) est proche d'une progression linéaire, notamment au niveau des batteries ayant un comportement de vieillissement normal, c'est-à-dire les batteries correctes.

Ce résultat est une indication probante que la surcharge cumulée ($Q_{ovch}$) est un indicateur de vieillissement électrique/électrochimique approprié pour le cas des applications de batterie de secours utilisant du plomb-acide ou d'autres électrochimies à électrolyte aqueux.

Estimation de la durée de vie d'une batterie en utilisant la corrélation entre la résistance interne ($R_{120s}$) et la surcharge cumulée ($Q_{ovch}$)

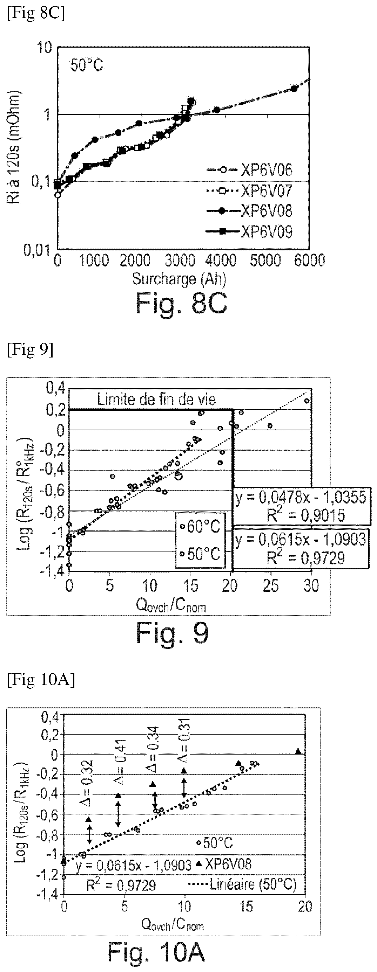

Les figures 8A, 8B et 8C montrent la corrélation entre les paramètres de diagnostic de batterie $R_{120s}$ et $Q_{ovch}$ pour les trois groupes de batteries précités, respectivement à 60°C et à 50°C.

Il ressort de ces figures 8A à 8C que le logarithme de la résistance des batteries correctes augmente linéairement avec la surcharge appliquée jusqu'à ce que celle-ci atteigne une valeur de 3500 à 4000 Ah. La résistance interne $R_{120s}$ commence à augmenter plus rapidement au-dessus de cette valeur de 3500 à 4000 Ah, ce qui signifie que la fin de vie de la batterie approche rapidement. Les portions linéaires des courbes sont similaires aux deux températures de vieillissement (50°C et 60°C), ce qui montre que cette relation semi-logarithmique entre la résistance interne ($R_{120s}$) et la surcharge cumulée ($Q_{ovch}$) peut être utilisée comme données d'étalonnage pour les diagnostics de batterie et les prévisions de durée de vie.

Cela étant, la résistance interne ($R_{120s}$) et la surcharge appliquée ($Q_{ovch}$) sont liées à la taille de chaque batterie en termes de capacité nominale et de tension nominale, c'est-à-dire le nombre d'accumulateurs connectés en série.

En outre, une très large gamme de modèles de batteries peut être fabriquée avec des composants identiques ne variant que par leurs dimensions hors-tout, i.e. avec la même épaisseur des matériaux actifs d'électrodes et de supports d'électrodes, et des séparateurs.

Par conséquent, la normalisation des paramètres de batterie $R_{120s}$ et $Q_{ovch}$ est nécessaire de sorte que la méthode de diagnostic soit adaptée à toute une gamme de batteries fabriquées à partir du même type de composants, i.e. de même nature chimique (alliages des supports collecteurs de courant, électrolyte, compositions des matériaux actifs d'électrodes et séparateurs).

Les inventeurs pensent que le paramètre le plus pratique pour la normalisation de la surcharge appliquée est la capacité nominale (Cn) de la batterie. Le paramètre résultant peut être noté « indice de surcharge » ou $N_{ovch}$ défini par la relation:

$$N_{ovch}=Q_{ovch}/Cn \ (11)$$

La normalisation de la résistance interne $R_{120s}$ quant à elle peut être avantageusement effectuée en utilisant l'impédance interne à haute fréquence 1kHz d'une batterie à l'état neuf, dans un état complètement chargé ou à partir de la valeur indiquée dans sa fiche produit, i.e. la valeur d'une batterie neuve de référence du même type.

Le paramètre (rn) résultant peut s'écrire :

$$rn = R_{120s}/R^0_{1kHz} \ (12).$$

La figure 9 présente les données d'étalonnage de la méthode, établies à partir des batteries correctes en utilisant les paramètres normalisés rn en fonction de $N_{ovch}$ dans un repère semi-logarithmique. Optionnellement, un travail d'étalonnage sur des batteries du même type permet de déterminer un ratio Rn-max au-delà duquel une batterie est à remplacer.

Une comparaison du Rn par rapport Rn-max permet donc optionnellement d'identifier également le besoin de remplacement d'une batterie

Les résultats de l'ajustement linéaire réalisé sur ces données d'étalonnage montrent que la relation semi-logarithmique entre la résistance interne $R_{120s}$ et la surcharge appliquée $N_{ovch}$ est une approche de modélisation empirique appropriée pour les diagnostics de batterie. Cet ajustement linéaire effectué sur des batteries des références vieillissant de façon correcte permet d'obtenir un droite d'étalonnage utilisée pour la suite de la méthode.

Le coefficient de détermination ($R^2$, soit le carré du coefficient de corrélation linéaire r) est supérieur à 0,9 aux deux températures de mesure (50°C et 60°C). Ces coefficients $R^2$ sont suffisamment proches pour établir que la variation de température n'aura pas d'impact significatif sur les prédictions de durée de vie de la batterie.

Par conséquent, l'ensemble des données expérimentales permet de retenir deux critères fiables pour la prédiction de fin de vie à savoir un seuil de résistance interne combiné à un seuil d'indice de surcharge.

Les données obtenues à partir du vieillissement des batteries défectueuses peuvent être utilisées pour dériver des critères de reconnaissance d'un comportement de vieillissement prématuré.

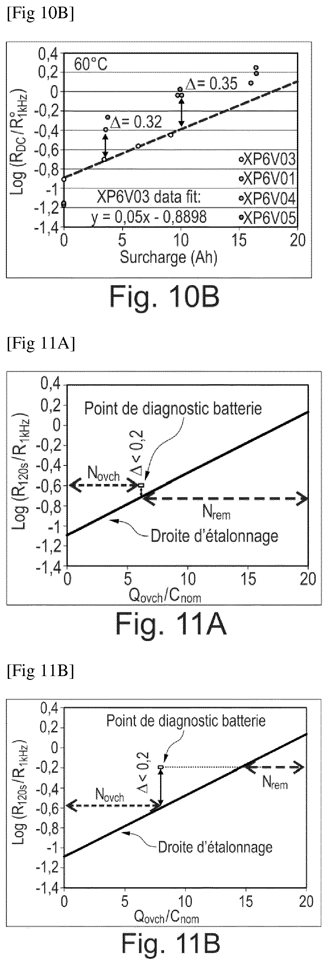

Cette analyse de données est présentée aux figures 10A et 10B, respectivement à 50°C et 60°C. On peut voir que pour la même quantité de surcharge, les batteries avec un comportement de vieillissement prématuré présentent un écart Δ positif du logarithme de la résistance interne rn normalisée. Pendant la première moitié de la durée de vie de la batterie, cet écart Δ varie de 0,3 à 0,4.

Compte tenu de ces résultats et de la dispersion des points de données observée sur la figure 9, on peut considérer qu'un écart Δ inférieur à 0,2 confirmera un vieillissement normal de la batterie tandis qu'un écart Δ supérieur à 0,2 indiquera un vieillissement prématuré.

Si l'écart Δ est supérieur à 0,2 alors un calcul ultérieur de la durée de vie restante de la batterie peut être réalisé ainsi qu'une alerte de l'utilisateur en cas de défaillance imminente de la batterie correspondante.

Les résultats des figures 9 et 10A, 10B montrent que la répétition ultérieure du même événement, c'est-à-dire un écart Δ > 0,2, peut être considérée comme une indicateur fiable d'une panne de batterie à venir, nécessitant un remplacement urgent de la batterie.

En revanche, la présence de batteries déjà remplacées récemment sera appréhendée par un événement de diagnostic avec un écart négatif, c'est-à-dire Δ < -0,2. Dans ce cas, une alerte de l'utilisateur avec un message du type « batterie récemment remplacée » pourra être mise en œuvre.

L'estimation de la durée de vie restante de la batterie est présentée schématiquement aux figures 11A et 11B respectivement pour deux points de données de diagnostic différentes. Dans le cas d'un vieillissement normal de la batterie, le point de données de diagnostic de la batterie est proche de la ligne d'étalonnage, i.e. c'est-à-dire que l'écart Δ > 0,2.

Dans ce cas, l'indice de surcharge restant ($N_{rem}$) peut être exprimé comme suit :

$$N_{rem} = N_{max} - N_{ovch} \ (13)$$

où $N_{max}$ correspond au maximum de la surcharge que peut tolérer la batterie jusqu'à sa défaillance et $N_{ovch}$ est la surcharge appliquée à la batterie depuis le début du lancement de l'exploitation du système de stockage de secours compte tenu que toutes les piles de la chaîne sont neuves. On précise ici que $N_{max}$ est égal à 20 pour la technologie Plomb-acide étudiée. Cette valeur vient des données montrées aux figures 2A, 3A, 7A et 7B.

En utilisant la capacité nominale (Cn) de la batterie, l'indice de surcharge restant ($N_{rem}$) est transformé en nombre restant d'ampères-heures de surcharge ($Q_{rem)}$ par la relation :

$$Q_{rem} = Cn * N_{rem} \quad (14).$$

Par ailleurs, le nombre d'ampère-heures de surcharge $Q_{rem}$ est égal au produit du courant de surcharge moyen $<I_{ovch}>$ et de la durée de vie restante de la batterie (RBLT) exprimée en heures, soit:

$$Q_{rem} = <I_{ovch}> * RBLT \quad (15).$$

Or, les données des figures 7A et 7B permettent de considérer le paramètre $<I_{ovch}>$ comme une constante qui peut être exprimée comme le rapport entre la surcharge appliquée, c'est-à-dire $Q_{ovch}$ ou $Cn*N_{ovch}$, et le temps de fonctionnement réel (BOT) de la batterie exprimé en heures, soit:

$$<I_{ovch}> = Cn*N_{ovch} / BOT \quad (16).$$

La combinaison des équations (13) à (16) permet d'aboutir à la relation suivante pour la durée de vie restante de la batterie :

$$RBLT = \left(\frac{N_{max}}{N_{ovch}} - 1\right) * BOT \quad (17).$$

Il va de soi que cette équitation (17) n'est pas applicable pour les batteries nouvellement installées car le terme $N_{max}/N_{ovch}$ sera très élevé. Dans les applications de stockage de secours, cela ne pose pas de problème car la maintenance du système de stockage est effectuée généralement une fois par an.

Pour les batteries présentant un vieillissement très exagéré, lorsque $N_{ovch} > N_{max}$, alors l'indicateur de RBLT sera négatif. Dans ce cas, le système de gestion de la batterie peut alerter l'utilisateur avec un message de remplacement urgent de la batterie.

Les figures 11A et 11B illustrent également le cas d'un vieillissement prématuré de la batterie, lorsque la résistance interne normalisée s'écarte de manière significative de la droite d'étalonnage. Dans ce cas, le paramètre $N_{ovch}$ peut être corrigé pour correspondre aux attentes d'une durée de vie plus courte de la batterie. Les données expérimentales des figures 10A et 10B indiquent que deux lectures consécutives de ce type peuvent entraîner la génération d'un message d'alerte à l'utilisateur de remplacement urgent de cette batterie.

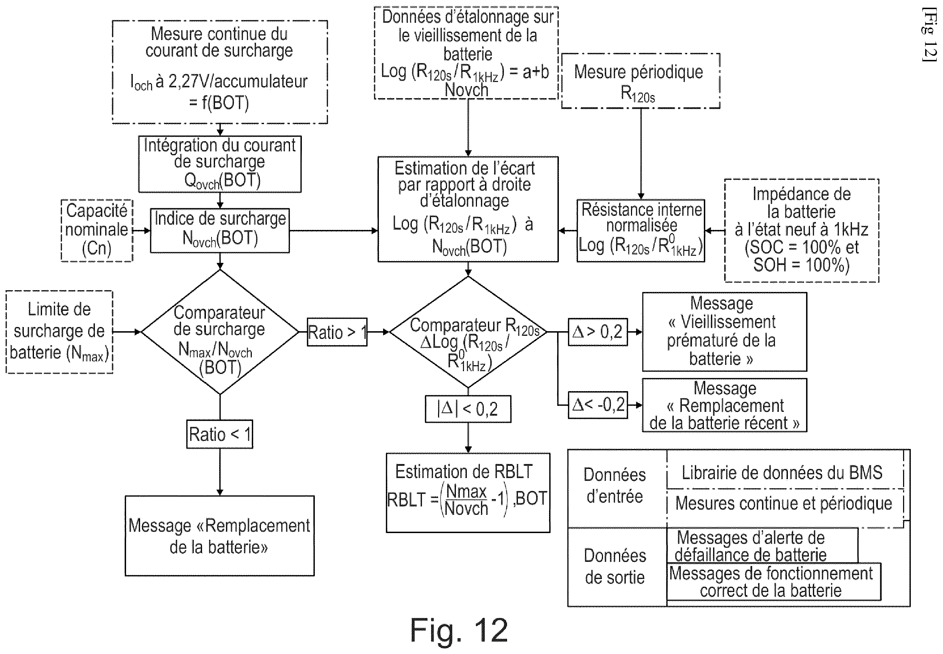

La figure 12 récapitule l'organigramme de l'algorithme de la méthode selon l'invention qui vient d'être décrite, avantageusement mise en œuvre dans un système de contrôle des batteries d'accumulateurs (BMS, acronyme anglo-saxon pour « Battery Management System »). Sur cette figure 12, les données de paramétrage de l'algorithme (données BMS) sont encadrées en traits tiret, les paramètres de batterie mesurés (surveillés) sont encadrées en traits point-tiret et les données de sortie sont en encadrés à fond gris. Les autres variables internes et procédures propres à la méthode selon l'invention sont encadrés en traits pleins.

L'invention n'est pas limitée aux exemples qui viennent d'être décrits ; on peut notamment combiner entre elles des caractéristiques des exemples illustrés au sein de variantes non illustrées.

D'autres variantes et améliorations peuvent être envisagées sans pour autant sortir du cadre de l'invention.

Dans l'exemple illustré, les résultats obtenus avec la technologie de batteries et le protocole expérimental indiquent que le paramètre de résistance interne $R_{120s}$ est en corrélation avec la résistance électrique de la couche de corrosion qui se développe sur le collecteur de courant positif. Au début du fonctionnement de la batterie, la couche de corrosion est mince, ce qui entraîne une très faible valeur de $R_{120s}$. Les données des figures 4A à 4D indiquent que la valeur de référence de la tension de la batterie peut être prise dans l'intervalle de 60 à 180s après le début de la décharge. Par exemple, le même type d'analyse a été effectué avec des valeur de résistance interne à 60s ($R_{60s}$) et des tracés très similaires à ceux illustrés aux figures 8A à 8C ont été obtenus.

Si le courant de décharge appliqué à la batterie est modifié, il est nécessaire de corriger la durée de la décharge d'essai et le choix de la tension de référence de la batterie.

La correction de la durée de décharge est proportionnelle au courant de décharge appliqué. Par exemple, si le courant de décharge est égal à Cn/0,5h (courant de décharge nominal à 30 min), l'intervalle de plage de temps sera deux fois plus court, c'est-à-dire de 30 à 90s (vs de 60 à 180s). A contrario, l'application d'un courant de décharge plus faible, par exemple Cn/2h correspondra à des périodes de décharge d'essai deux fois plus longues (120 à 360s).

La correction de la tension de référence à différents courants de décharge nécessite une évaluation du transitoire de tension de décharge, afin d'obtenir une résistance interne sous courant continu, normalisée qui restant dans l'intervalle 0,01 à 0,1 mOhms, c'est-à-dire qu'elles doivent être au moins un ordre de grandeur plus petit que l'impédance interne de la batterie mesurée sous courant alternatif à 1 kHz avec un état de charge SOC = 100 % et un état de santé SOH = 100 %.

La méthode de diagnostic de batterie qui vient d'être décrite nécessite la séparation des ampères-heures correspondant au processus de décharge de l'électricité utilisée dans les principales réactions de charge. Dans l'exemple illustré, avec la technologie de batteries et le protocole expérimental, la séparation a été effectuée à l'aide des données des expériences de décharge, c'est-à-dire que le nombre d'ampères-heures déchargés est soustrait de la charge globale appliquée. C'est l'approche la plus précise du point de vue électrochimique. Une stratégie alternative pour l'estimation de la surcharge $Q_{ovch}$ est de ne comptabiliser que l'ampère-heure injecté en mode de charge flottante, c'est-à-dire lorsque la tension est égale à 2,27V/accumulateur dans le cas réel. Cette approche peut être très efficace si la recharge principale est effectuée en mode courant constant / tension constante avec une limite de tension de 2,35 à 2,40V/accumulateur avec une durée relativement courte. Par exemple, la tension constante est appliquée sur une durée de 10 à 15h. Dans de telles conditions, la capacité précédemment déchargée est renvoyée à la batterie avec une surcharge minimale, c'est-à-dire que l'efficacité faradique est comprise entre 97 et 98 %. Si la recharge est effectuée en utilisant une tension limite de 2,27V/accumulateur, la correction de la surcharge peut être effectuée en omettant les ampères-heures injectés dans la batterie pendant les premières 24 à 48h en mode de charge flottante. Une telle stratégie est raisonnable car la durée correspondante est bien inférieure à la durée de vie type des batteries annoncée par leurs fabricants. Par exemple, la technologie utilisée « Sprinter XP6V2800 » est indiquée avec une durée de vie de 8 ans à 20°C.

**Liste des références citées**

[1]: D.O. Feder, M.J. Hvalac and S.J. McShane, "Updated status of conductance/capacity correlation studies to determine state-of-health of automotive and stand-by lead/acid batteries", J Power Sources 48 (1994) 135.

[2]: Présentation d'Avicenne Energy "Batteries durables : une nouvelle réglementation cadre et perspectives de marché" organisé par EUROBAT, Association des fabricants européens de batteries automobiles et industrielles, webinaire du 11 mars 2021.

https://www.eurobat.org/events/event/48-eurobat-webiinar-sustainable-batteries-a-new-regulatory-framework-and-market-outlook

**Revendications**

1. Méthode de diagnostic d'un accumulateur ou batterie à électrolyte aqueux, notamment une batterie plomb-acide, comprenant les étapes suivantes :

   a/ mesure continue d'un courant de surcharge ($I_{ovch}$) appliquée à la batterie ;
   b/ mesure périodique, sous courant continu, de la résistance interne ($R_{120s}$) de la batterie,
   c/ normalisation d'un paramètre issu du courant de surcharge mesuré selon l'étape a/ et de la résistance interne mesurée selon l'étape b/ ;
   d/ estimation de l'écart du logarithme de la résistance interne normalisée selon l'étape c/, considérée pour le paramètre issu du courant de surcharge normalisé selon l'étape c/, par rapport à une droite d'étalonnage, obtenue à partir d'une régression linéaire de mesures d'étalonnage de résistance interne et courant de surcharge d'une batterie de référence ;
   e/ comparaison de l'écart ($\Delta$) estimé par rapport une valeur seuil prédéterminée en fonction du type de la batterie :

   • si l'écart est positif et supérieur à cette valeur seuil alors nécessité de changer la batterie du fait de son vieillissement prématuré ;
   • si l'écart est négatif et inférieur à cette valeur seuil alors pas de nécessité de changer la batterie.

2. Méthode de diagnostic selon la revendication 1, le paramètre issu du courant de surcharge mesuré étant l'intégration ($Q_{ovch}$) du courant de surcharge flottante lorsque la tension de la batterie est maintenue à une valeur de charge flottante comprise entre 2,25V et 2,3V/accumulateur.

**3.** Méthode de diagnostic selon la revendication 1 ou 2, la normalisation de la résistance interne selon l'étape c/ étant réalisée en divisant la résistance interne mesurée ($R_{120s}$) par la résistance interne de la batterie neuve mesurée sous courant alternatif à 1kHz ou d'une batterie neuve de référence du même type.

**4.** Méthode de diagnostic selon la revendication 2 ou selon la revendication 3 en combinaison avec la revendication 2, la normalisation du courant de surcharge selon l'étape c/ étant réalisée en divisant l'intégration du courant de surcharge mesuré ($Q_{ovch}$) par la capacité nominale (Cn) de la batterie, définissant l'indice de surcharge ($N_{ovch}$).

**5.** Méthode de diagnostic selon la revendication 4, comprenant en outre les étapes suivantes :

f/ estimation du rapport ($\frac{Nmax}{Novch}$) entre la limite de surcharge ($N_{max}$) et l'indice de surcharge ($N_{ovch}$) ;

g/ comparaison du rapport ($\frac{Nmax}{Novch}$) estimé à l'étape f/ par rapport à 1 :

• si le rapport ($\frac{Nmax}{Novch}$) estimé est inférieur à 1, alors nécessité de changer la batterie du fait de son vieillissement normal dépassé.

**6.** Méthode de diagnostic selon la revendication 5, comprenant en outre l'étape suivante :

• si le rapport ($\frac{Nmax}{Novch}$) comparé à l'étape g/ est supérieur à 1, et
• si la valeur absolue de l'écart (Δ) estimé à l'étape d/ est inférieur à la valeur seuil prédéterminée, alors
h/ détermination de la durée de vie restante de la batterie (RBLT) à partir de l'équation :

$$RBLT = \left(\frac{N_{max}}{N_{ovch}} - 1\right) * BOT$$

dans laquelle BOT désigne la durée de mise en service réelle de la batterie.

**7.** Méthode de diagnostic selon l'une des revendications précédentes, la mesure périodique de la résistance interne ($R_{120s}$) de la batterie selon l'étape b/ étant réalisée par l'application d'un courant de charge ou de décharge sur un intervalle de temps fixe.

**8.** Méthode de diagnostic selon la revendication 7, l'intervalle de temps fixe étant entre 60 et 180 secondes pour un courant de décharge correspondant à la capacité nominale (Cn).

**9.** Système de contrôle d'une batterie à électrolyte aqueux (BMS) configuré pour la mise en œuvre de la méthode selon l'une des revendications précédentes, le système comprenant des capteurs de mesure et un processeur configuré pour fournir, à partir des mesures réalisées par les capteurs, à l'utilisateur des messages d'alerte soit de de défaillance de la batterie, soit de fonctionnement correct de la batterie, et de préférence un message d'indication de la durée de vie restante de la batterie (RBLT).

**10.** Utilisation de la méthode selon l'une des revendications 1 à 8 ou du système selon la revendication 9 dans une application où la batterie sert de stockage d'électricité de secours, telle que dans les stations de télécommunications, les centres de données, les installations nucléaires, ou sert de support et de sauvegarde du réseau basse tension d'une voiture électrique.

**Patentansprüche**

**1.** Verfahren zur Diagnose eines Akkumulators oder einer Batterie mit wässrigem Elektrolyt, insbesondere einer Blei-Säure-Batterie, das die folgenden Schritte aufweist:

a/ kontinuierliche Messung eines an die Batterie angelegten Überlaststroms ($I_{ovch}$) ;

b/ periodische Messung des Innenwiderstands ($R_{120s}$) der Batterie unter Gleichstrom;

c/ Normalisierung eines Parameters, der sich aus dem gemäß Schritt a/ gemessenen Überlaststrom und dem gemäß Schritt b/ gemessenen Innenwiderstand ergibt;

d) Schätzung der Abweichung des Logarithmus des normalisierten Innenwiderstands gemäß Schritt c), berücksichtigt für den Parameter, der sich aus dem normalisierten Überlaststrom gemäß Schritt c) ergibt, bezüglich einer Kalibrierungsgeraden, die aus einer linearen Regression der Kalibrierungsmessungen des Innenwiderstands und des Überlaststroms einer Referenzbatterie erhalten wurde;

e/ Vergleich der geschätzten Abweichung ($\Delta$) mit einem vorab festgelegten Schwellenwert entsprechend dem Batterietyp:

• Wenn die Abweichung positiv ist und diesen Schwellenwert überschreitet, muss die Batterie aufgrund ihrer vorzeitigen Alterung ausgetauscht werden;

• wenn die Abweichung negativ ist und diesen Schwellenwert unterschreitet, muss die Batterie nicht ausgetauscht werden.

2. Diagnoseverfahren nach Anspruch 1, wobei der aus dem gemessenen Überlaststrom abgeleitete Parameter die Integration ($Q_{ovch}$) des Erhaltungsüberstroms ist, wenn die Batteriespannung auf einem Erhaltungsladewert zwischen 2,25 V und 2,3 V/Akkumulator gehalten wird.

3. Diagnoseverfahren nach Anspruch 1 oder 2, wobei die Normalisierung des Innenwiderstands gemäß Schritt c/ durch Division des gemessenen Innenwiderstands ($R_{120s}$) durch den unter Wechselstrom bei 1 kHz gemessenen Innenwiderstand der neuen Batterie oder einer neuen Referenzbatterie desselben Typs erfolgt.

4. Diagnoseverfahren nach Anspruch 2 oder nach Anspruch 3 in Kombination mit Anspruch 2, wobei die Normalisierung des Überlaststroms gemäß Schritt c/ durch Division der Integration des gemessenen Überlaststroms ($Q_{ovch}$) durch die Nennkapazität (Cn) der Batterie erfolgt, wodurch der Überlastindex ($N_{ovch}$) definiert wird.

5. Diagnoseverfahren nach Anspruch 4, das zusätzlich die folgenden Schritte aufweist:

f/ Schätzung des Verhältnisses ( $\dfrac{N_{max}}{N_{ovch}}$ ) zwischen der Überlastgrenze ($N_{max}$) und dem Überlastindex ($N_{ovch}$);

g/ Vergleich des in Schritt f/ geschätzten Verhältnisses ( $\dfrac{N_{max}}{N_{ovch}}$ ) im Verhältnis zu 1:

• Wenn das geschätzte Verhältnis ( $\dfrac{N_{max}}{N_{ovch}}$ ) unter 1 liegt, muss die Batterie aufgrund ihrer normalen Alterung ausgetauscht werden.

6. Diagnoseverfahren nach Anspruch 5, das zusätzlich den folgenden Schritt aufweist:

• Wenn das in Schritt g/ verglichene Verhältnis ( $\dfrac{N_{max}}{N_{ovch}}$ ) größer als 1 ist und

• wenn der absolute Wert der in Schritt d/ geschätzten Abweichung ($\Delta$) unter dem vorgegebenen Schwellenwert liegt, dann

h/ Bestimmung der verbleibenden Batterielebensdauer (RBLT) anhand der folgenden Gleichung:

$$RBLT = \left( \frac{N_{max}}{N_{ovch}} - 1 \right) * BOT$$

wobei BOT die tatsächliche Betriebsdauer der Batterie bezeichnet.

7. Diagnoseverfahren nach einem der vorhergehenden Ansprüche, wobei die periodische Messung des Innenwiderstands ($R_{120s}$) der Batterie gemäß Schritt b/ durch Anlegen eines Lade- oder Entladestromes über ein festes Zeitintervall erfolgt.

8. Diagnoseverfahren nach Anspruch 7, wobei das feste Zeitintervall für einen Entladestrom, der der Nennkapazität ($C_n$) entspricht, zwischen 60 und 180 Sekunden beträgt.

9. Steuersystem für eine Batterie mit wässrigem Elektrolyt (BMS), das für die Umsetzung des Verfahrens nach einem der vorhergehenden Ansprüche konfiguriert ist, wobei das System Messsensoren und einen Prozessor aufweist, der so konfiguriert ist, dass er dem Benutzer auf der Grundlage der von den Sensoren durchgeführten Messungen Warnmeldungen entweder über einen Ausfall der Batterie oder über den ordnungsgemäßen Betrieb der Batterie und vorzugsweise eine Meldung über die verbleibende Lebensdauer der Batterie (RBLT) liefert.

10. Verwendung des Verfahrens nach einem der Ansprüche 1 bis 8 oder des Systems nach Anspruch 9 in einer Anwendung, bei der die Batterie als Notstromspeicher dient, beispielsweise in Telekommunikationsstationen, Rechenzentren, Kernkraftwerken, oder als Unterstützung und Sicherung des Niederspannungsnetzes eines Elektroautos.

**Claims**

1. Method for diagnosing an accumulator or battery employing an aqueous electrolyte, and especially a lead-acid battery, comprising the following steps:

   a/ continuously measuring an over-charging current ($I_{ovch}$) applied to the battery;
   b/ periodically measuring, under DC current, the internal resistance ($R_{120s}$) of the battery;
   c/ normalizing a parameter derived from the over-charging current measured in step a/ and the internal resistance measured in step b/;
   d/ estimating the deviation of the logarithm of the internal resistance normalized in step c/, considered for the parameter derived from the over-charging current normalized in step c/, with respect to a straight calibration line, obtained from a linear regression of calibration measurements of internal resistance and over-charging current of a reference battery;
   e/ comparing the estimated deviation ($\Delta$) to a predetermined threshold value depending on the type of battery:

   • if the deviation is positive and higher than this threshold value then the battery needs to be changed because of its premature ageing;
   • if the deviation is negative and lower than this threshold value then there is no need to change the battery.

2. Diagnosing method according to Claim 1, the parameter derived from the measured over-charging current being the integral ($Q_{ovch}$) of the float over-charging current when the voltage of the battery is maintained at a float-charging value comprised between 2.25 V and 2.3 V/accumulator.

3. Diagnosing method according to Claim 1 or 2, the normalization of the internal resistance in step c/ being carried out by dividing the measured internal resistance ($R_{120s}$) by the internal resistance of the new battery measured under AC current at 1 kHz or of a new reference battery of the same type.

4. Diagnosing method according to Claim 2 or according to Claim 3 in combination with Claim 2, the normalization of the over-charging current in step c/ being carried out by dividing the integral of the measured over-charging current ($Q_{ovch}$) by the nominal capacity ($C_n$) of the battery, defining an over-charging index ($N_{ovch}$).

5. Diagnosing method according to Claim 4, further comprising the following steps:

   f/ estimating the ratio ($\frac{N_{max}}{N_{ovch}}$) between the over-charging limit ($N_{max}$) and the over-charging index ($N_{ovch}$) ;

   g/ comparing the ratio ($\frac{N_{max}}{N_{ovch}}$) estimated in step f/ to 1:

   • if the estimated ratio ($\frac{N_{max}}{N_{ovch}}$) is lower than 1, then the battery needs to be changed because its normal ageing has been exceeded.

6. Diagnosing method according to Claim 5, further comprising the following step:

   • if the ratio ( $\frac{\text{Nmax}}{\text{Novch}}$ ) compared in step g/ is higher than 1, and
   • if the absolute value of the deviation (Δ) estimated in step d/ is lower than the predetermined threshold value, then
   h/ determining the remaining lifespan (RBLT) of the battery using the equation:

$$RBLT = \left( \frac{N_{max}}{N_{ovch}} - 1 \right) * BOT$$

   in which BOT designates the actual time for which the battery has been in service.

7. Diagnosing method according to one of the preceding claims, the periodic measurement of the internal resistance ($R_{120s}$) of the battery in step b/ being carried out with application of a charging or discharging current over a fixed time interval.

8. Diagnosing method according to Claim 7, the fixed time interval being between 60 and 180 seconds for a discharging current corresponding to the nominal capacity (Cn).

9. System (BMS) for controlling a battery employing an aqueous electrolyte, configured to implement the method according to one of the preceding claims, the system comprising measurement sensors and a processor that is configured to deliver, on the basis of the measurements taken by the sensors, to the user, messages advising either of failure of the battery, or of correct operation of the battery, and preferably a message indicating the remaining lifespan (RBLT) of the battery.

10. Use of the method according to one of Claims 1 to 8 or of the system according to Claim 9 in an application in which the battery serves as a standby store of electricity, such as in telecommunication base stations, data centres, nuclear plants, or serves as a base and backup for the low-voltage network of an electric car.

[Fig 1A]

(ETAT DE L'ART)     Fig. 1A

[Fig 1B]

(ETAT DE L'ART)     Fig. 1B

[Fig 2A]

(ETAT DE L'ART)     Fig. 2A

[Fig 2B]

Fig. 2B

(ETAT DE L'ART)

[Fig 3A]

Fig. 3A

(ETAT DE L'ART)

[Fig 3B]

Fig. 3B

(ETAT DE L'ART)

[Fig 4A]

XP6V03 / Nov 2018 / 60°C ---- CU ini
········· CU01
-·-·- CU02
——— CU03

Tension (Volts)

Temps (minutes)

## Fig. 4A

[Fig 4B]

XP6V03 / Nov 2018 / 60°C ---- CU ini
········· CU01
-··- CU02
——— CU03

Tension (Volts)

Temps (minutes)

## Fig. 4B

[Fig 4C]

XP6V01 / Mai 2019 / 60°C ---- CU ini
········· CU01
-·-·- CU02
——— CU03

Tension (Volts)

Temps (minutes)

## Fig. 4C

[Fig 4D]

Fig. 4D

[Fig 5A]

Fig. 5A

[Fig 5B]

Fig. 5B

[Fig 6A]

Fig. 6A

[Fig 6B]

Fig. 6B

[Fig 7A]

Fig. 7A

[Fig 7B]

Fig. 7B

[Fig 8A]

Fig. 8A

[Fig 8B]

Fig. 8B

[Fig 8C]

Fig. 8C

[Fig 9]

Fig. 9

[Fig 10A]

Fig. 10A

[Fig 10B]

Fig. 10B

[Fig 11A]

Fig. 11A

[Fig 11B]

Fig. 11B

[Fig 12]

Mesure continue du
courant de surcharge

$I_{och}$ à 2,27V/accumulateur
= f(BOT)

Données d'étalonnage sur
le vieillissement de la
batterie
Log ($R_{120s}/R_{1kHz}$) = a+b
Novch

Mesure périodique
$R_{120s}$

Intégration du courant
de surcharge
$Q_{ovch}$(BOT)

Capacité
nominale
(Cn)

Indice de surcharge
$N_{ovch}$(BOT)

Estimation de l'écart
par rapport à droite
d'étalonnage
Log ($R_{120s}/R_{1kHz}$) à
$N_{ovch}$(BOT)

Résistance interne
normalisée
Log ($R_{120s}/R^0_{1kHz}$)

Impédance de
la batterie
à l'état neuf à 1kHz
(SOC = 100% et
SOH = 100%)

Limite de
surcharge de
batterie ($N_{max}$)

Comparateur
de surcharge
$N_{max}/N_{ovch}$
(BOT)

Ratio > 1

Comparateur $R_{120s}$
$\Delta$Log ($R_{120s}/R^0_{1kHz}$)

$\Delta$ > 0,2

Message
« Vieillissement
prématuré de la
batterie »

Ratio < 1

$|\Delta|$ < 0,2

$\Delta$ < -0,2

Message
« Remplacement
de la batterie récent »

Message «Remplacement
de la batterie»

Estimation de RBLT
RBLT = $\left(\dfrac{Nmax}{Novch} -1\right)$,BOT

| Données d'entrée | Librairie de données du BMS |
| | Mesures continue et périodique |
| Données de sortie | Messages d'alerte de défaillance de batterie |
| | Messages de fonctionnement correct de la batterie |

Fig. 12

## RÉFÉRENCES CITÉES DANS LA DESCRIPTION

**Documents brevets cités dans la description**

- US 2018267111 A1

**Littérature non-brevet citée dans la description**

- **D.O. FEDER** ; **M.J. HVALAC** ; **S.J. MCSHANE**. Updated status of conductance/capacity correlation studies to determine state-of-health of automotive and stand-by lead/acid batteries. *J Power Sources*, 1994, vol. 48, 135

- Présentation d'Avicenne Energy "Batteries durables : une nouvelle réglementation cadre et perspectives de marché. Association des fabricants européens de batteries automobiles et industrielles, 11 March 2021